(19) Europäisches Patentamt
European Patent Office
Office européen des brevets

(11) **EP 3 528 013 A1**

(12) **EUROPÄISCHE PATENTANMELDUNG**

(43) Veröffentlichungstag:
21.08.2019   Patentblatt 2019/34

(51) Int Cl.:
*G01T 7/00* (2006.01)

(21) Anmeldenummer: **19166715.3**

(22) Anmeldetag: **17.11.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.10.2011   PCT/EP2011/005353**

(62) Dokumentnummer(n) der früheren Anmeldung(en) nach Art. 76 EPÜ:
**11790560.4 / 2 771 720**

(71) Anmelder:
• **Helmholtz Zentrum München Deutsches Forschungszentrum für Gesundheit und Umwelt GmbH**
  **85764 Neuherberg (DE)**
• **Klein, Rolf-Dieter**
  **80809 München (DE)**
• **Reichl, Mathias**
  **93309 Kelheim (DE)**

(72) Erfinder:
• **Hoeschen, Christoph**
  **39114 Magdeburg (DE)**
• **Reichl, Mathias**
  **93309 Kelheim (DE)**
• **Klein, Rolf-Dieter**
  **80809 München (DE)**

(74) Vertreter: **v. Bezold & Partner Patentanwälte - PartG mbB**
  **Akademiestraße 7**
  **80799 München (DE)**

Bemerkungen:
Diese Anmeldung ist am 02-04-2019 als Teilanmeldung zu der unter INID-Code 62 erwähnten Anmeldung eingereicht worden.

(54) **ÜBERWACHUNGSEINRICHTUNG ZUR UMWELTÜBERWACHUNG**

(57)   Die Erfindung betrifft eine Überwachungseinrichtung (6) zur Umweltüberwachung, insbesondere zur Umweltüberwachung von radioaktiver Strahlung, mit mindestens einem Empfänger zum Empfangen von Messwerten einer potentiell gesundheitsgefährdenden Umweltgröße, sowie mit einer Recheneinheit (10) zur Berechnung eines Gefahrenhinweises (4.1-4.4) in Abhängigkeit von den Messwerten. Es wird vorgeschlagen, dass der Empfänger ausgelegt ist für den Empfang der Messwerte von einer Vielzahl von räumlich verteilt angeordneten elektronischen Endgeräten (2.1-2.4), insbesondere von Mobiltelefonen mit einem Bildsensor zur Messung der radioaktiven Strahlung. Weiterhin umfasst die Erfindung ein entsprechendes Endgerät (2.1-2.4) und ein komplettes Überwachungssystem mit einer Überwachungseinrichtung und zahlreichen Endgeräten (2.1-2.4) zur Messung der Umweltgröße.

Fig. 1

EP 3 528 013 A1

**Beschreibung**

Die Erfindung betrifft eine Überwachungseinrichtung zur Umweltüberwachung, insbesondere zur Umweltüberwachung von radioaktiver Strahlung. Weiterhin betrifft die Erfindung ein Entgerät zur Bereitstellung von Messdaten für die erfindungsgemäße Überwachungseinrichtung. Darüber hinaus umfasst die Erfindung auch ein Überwachungssystem mit zahlreichen derartigen Endgeräten und einer zentralen Überwachungseinrichtung.

In Deutschland betreibt das Deutsche Bundesamt für Strahlenschutz ein sogenanntes ODL-Messnetz (ODL: Orts-Dosisleistung), das mittels einer Vielzahl von flächendeckend verteilt angeordneten Messstellen die Orts-Dosisleistung der Gammastrahlung am jeweiligen Messort misst, wobei die Messwerte von den einzelnen Messstellen drahtgebunden über das Telefonnetz zu einem Messnetzknoten (Auswertungseinheit) übertragen werden. Der Messnetzknoten kann dann aus der Vielzahl der Messwerte von den verschiedenen Messstellen eine Strahlungskarte berechnen, welche die geografische Verteilung der Orts-Dosisleistung wiedergibt.

Nachteilig an diesem bekannten ODL-Messnetz sind der hohe Infrastrukturaufwand für die Bereitstellung und den Betrieb der Vielzahl von Messstellen sowie die hohen Kosten bei hohen Ansprüchen an ortsaufgelöste Erkenntnisse über die Verteilung der radioaktiven Strahlung.

Der Erfindung liegt deshalb die Aufgabe zugrunde, ein entsprechendes Überwachungssystem mit einem wesentlich geringeren Infrastrukturaufwand zu schaffen.

Diese Aufgabe wird durch eine Überwachungseinrichtung (Auswertungseinheit), entsprechend angepasste Endgeräte (Messstellen) und ein Überwachungssystem gemäß den Ansprüchen gelöst.

Die Erfindung beruht auf der technisch-physikalischen Erkenntnis, dass radioaktive Strahlung nicht nur von speziell für diesen Zweck ausgelegten Strahlungssensoren (z.B. Geiger-Müller-Zählrohren) gemessen werden kann, sondern auch von herkömmlichen Bildsensoren (z.B. CCD-Sensoren, CMOS-Sensoren), die in Digitalkameras von modernen Endgeräten (z.B. Mobiltelefone, Notebooks, Laptops, etc.) enthalten sind. Die Erfindung sieht deshalb vor, dass derartige Bildsensoren in modernen Endgeräten auch zur Strahlungsmessung eingesetzt werden, was den Aufbau eines Messnetzes mit einem sehr geringen Infrastrukturaufwand ermöglicht, da der Aufwand für die Bereitstellung und den Betrieb der einzelnen Messstellen entfällt. Darüber hinaus ermöglicht dieser technische Gedanke den Aufbau eines sehr dichten Messnetzes, da beispielsweise in Deutschland mehrere Millionen Mobiltelefone betrieben werden, die über einen Bildsensor verfügen und deshalb zur Strahlungsmessung geeignet sind. Durch die Vielzahl der zur Strahlungsmessung eingesetzten Endgeräte besteht darüber hinaus die vorteilhafte Möglichkeit einer statistischen Auswertung der Vielzahl von Messwerten, wodurch die Genauigkeit deutlich gesteigert werden kann.

Die Erfindung umfasst deshalb zunächst eine zentrale Überwachungseinrichtung ähnlich den Messnetzknoten des bekannten ODL-Messnetzes. Diese zentrale Überwachungseinrichtung verfügt über einen Empfänger zum Empfang von Messwerten einer potentiell gesundheitsgefährdenden Umweltgröße, wobei es sich vorzugsweise um eine Strahlungsgröße handelt, die radioaktive Strahlung wiedergibt.

Die Erfindung ist jedoch hinsichtlich der überwachten Umweltgröße nicht auf die Überwachung von radioaktiver Strahlung beschränkt, sondern lässt sich grundsätzlich auch zur Überwachung anderer Umweltgrößen einsetzen, die potentiell gesundheitsgefährdend sind. Beispielsweise kann es sich bei der überwachten Umweltgröße um Schadstoffkonzentrationen handeln. Entscheidend ist lediglich, dass die interessierende Umweltgröße von den Endgeräten gemessen werden kann.

Darüber hinaus verfügt die erfindungsgemäße Überwachungseinrichtung über eine Recheneinheit zur Berechnung eines Gefahrenhinweises in Abhängigkeit von den Messwerten.

Die erfindungsgemäße Überwachungseinrichtung unterscheidet sich von den Messnetzknoten des bekannten ODL-Messnetzes dadurch, dass der Empfänger ausgelegt ist für den Empfang der Messwerte von einer Vielzahl von räumlich verteilt angeordneten elektronischen Endgeräten (z.B. Mobiltelefonen mit einem Bildsensor zur Messung der radioaktiven Strahlung), wohingegen die Messnetzknoten des ODL-Messnetzes die Messwerte von fest installierten Messstellen empfangen.

Der Empfang der Messwerte von den einzelnen Endgeräten erfolgt vorzugsweise drahtlos, beispielsweise über ein zelluläres Mobilfunknetz. Es ist jedoch im Rahmen der Erfindung grundsätzlich auch möglich, die Messwerte von den einzelnen Endgeräten drahtgebunden zu der Überwachungseinrichtung zu übertragen oder über eine Funkverbindung. Vorzugsweise wird jedoch zur Übertragung der Messwerte von den einzelnen Endgeräten zu der zentralen Überwachungseinrichtung ein Sender in den Endgeräten genutzt, der für die Erfüllung der normalen Funktion des Endgeräts ohnehin vorhanden ist, so dass sich im Rahmen der Erfindung herkömmliche Endgeräte eignen.

Darüber hinaus weist die erfindungsgemäße Überwachungseinrichtung vorzugsweise auch einen Sender auf, um einen Gefahrenhinweis an die elektronischen Endgeräte zu übertragen, wobei der Gefahrenhinweis die Nutzer der Endgeräte über eine mögliche Gesundheitsgefahr aufgrund der Messwerte der Umweltgröße informiert. Im Gegensatz zu dem eingangs beschriebenen herkömmlichen ODL-Messnetz erfolgt also bei der Erfindung vorzugsweise eine bidirektionale Kommunikation zwischen den einzelnen Endgeräten einerseits und der Überwachungseinrichtung andererseits.

Der vorstehend erwähnte Gefahrenhinweis für die Nutzer der Endgeräte wird im Rahmen der Erfindung vorzugsweise in Abhängigkeit von der geografischen Position der einzelnen Endgeräte berechnet. Dies bedeutet, dass die Nutzer der Endgeräte in Abhängigkeit von ihrer aktuellen geografischen Position unterschiedliche Gefahrenhinweise erhalten. Falls sich beispielsweise ein Nutzer eines Endgeräts in einem Gebiet mit hoher Strahlung befindet, so kann der Gefahrenhinweis den Nutzer anweisen, das gefährdete Gebiet schnellstmöglich zu verlassen. Falls sich dagegen ein Nutzer eines Endgeräts in einem Gebiet mit geringen und gesundheitlich unbedenklichen Strahlungswerten befindet, so kann der Gefahrenhinweis den Nutzer über die Unbedenklichkeit eines weiteren Aufenthalts in diesem Gebiet informieren und dadurch Panik vermeiden.

In einer Variante der Erfindung wird die geografische Position der einzelnen Endgeräte jeweils von den einzelnen Endgeräten ermittelt, wozu bei modernen Mobiltelefonen ein integriertes GPS-Modul (GPS: Global Positioning System) verwendet werden kann. Die geografische Position der einzelnen Endgeräte wird dann von den einzelnen Endgeräten zusammen mit dem jeweiligen Messwert der überwachten Umweltgröße an die Überwachungseinrichtung übertragen. Hierbei ist zu erwähnen, dass die geografische Position der einzelnen Endgerät nicht nur durch ein GPS-Modul ermittelt werden kann, sondern auch durch ein anderen Satellitennavigationssystems, wie beispielsweise das Galileo-System.

In einer anderen Variante der Erfindung wird die geografische Position der einzelnen Endgeräte dagegen nicht durch die Endgeräte selbst ermittelt, sondern von der Überwachungseinrichtung. Dies bietet den Vorteil, dass auch die geografische Position von solchen Endgeräten ermittelt werden kann, die kein integriertes GPS-Modul aufweisen.

Bei einem zellulären Mobilfunknetz kann die geografische Position der einzelnen Endgeräte beispielsweise durch eine Zellenortung der Funkzelle des jeweiligen Endgeräts in dem zellulären Mobilfunknetz ermittelt werden. Diese Zellenortung kann in dem Mobilfunkgerät oder in der zentralen Überwachungseinrichtung durchgeführt werden.

Eine weitere Möglichkeit der Bestimmung der geografischen Position der einzelnen Endgeräte besteht darin, dass bei einer WLAN-Anbindung (WLAN: Wireless Local Area Network) der Endgeräte der zugehörige Wireless-Access-Point geortet wird, dessen geografische Position dann näherungsweise mit der Position des jeweiligen Endgeräts übereinstimmt.

Darüber hinaus umfasst die erfindungsgemäße Überwachungseinrichtung vorzugsweise eine Geodatenbank, welche geografische Daten eines geografischen Gebiets enthält, in dem sich die Endgeräte befinden.

Beispielsweise können in der Geodatenbank Geländedaten gespeichert sein, die für die Abschwächung radioaktiver Strahlung relevant sind. Falls sich beispielsweise eine Strahlungsquelle in einem Tal befindet, so wird die von der Strahlungsquelle ausgehende radioaktive Strahlung von umgebenden Bergen abgeschwächt.

Darüber hinaus kann die Geodatenbank auch Daten über Verkehrswege (z.B. Straßen, Schienenwege, etc.) enthalten, um die Nutzer der Endgeräte im Rahmen des Gefahrenhinweises über optimale Verkehrswege für eine Flucht zu informieren.

Ferner kann die Geodatenbank auch Informationen über Gebäudedaten (z.B. Positionen von Schutzeinrichtungen, wie beispielsweise Zivilschutzbunkern) enthalten, um die Nutzer der Endgeräte im Rahmen der Gefahrenhinweise zu bestimmten Schutzeinrichtungen zu leiten.

Die Recheneinheit in der zentralen Überwachungseinrichtung berechnet dann den Gefahrenhinweis nicht nur in Abhängigkeit von den in von den einzelnen Endgeräten empfangenen Messwerten der überwachten Umweltgröße, sondern auch in Abhängigkeit von den in der Geodatenbank gespeicherten geografischen Daten.

In einem bevorzugten Ausführungsbeispiel der Erfindung berechnet die Recheneinheit in der zentralen Überwachungseinrichtung eine räumliche Verteilung einer Strahlenexposition in Abhängigkeit von den von den Endgeräten empfangenen Messwerten unter Berücksichtigung von den in der Geodatenbank gespeicherten geografischen Daten und auch unter Berücksichtigung der geografischen Positionen der einzelnen Endgeräte. Auf diese Weise kann die Überwachungseinrichtung eine sehr genaue Strahlungskarte des überwachten Gebiets erstellen, wobei die Strahlungskarte beispielsweise die geografische Verteilung der Orts-Dosisleistung in dem überwachten Gebiet wiedergeben kann.

In dem bevorzugten Ausführungsbeispiel der Erfindung weist die Überwachungseinrichtung eine Statistikeinheit auf, um die von den Endgeräten gemessenen Messwerte der Umweltgröße und der zugehörigen geografischen Position der Endgeräte statistisch auszuwerten.

Im Rahmen der statistischen Auswertung können beispielsweise Ausreißer der Messwerte ermittelt werden, damit die Ausreißer bei der weiteren Auswertung nicht verfälschend berücksichtigt werden.

Weiterhin ist zu erwähnen, dass die Endgeräte in der Regel nicht für einen Einsatz als Strahlungsmessgeräte ausgelegt sind und deshalb nur einen relativ ungenauen, nicht kalibrierten Messwert ausgeben. Allerdings haben beispielsweise die als Bildsensoren in den Endgeräten vorhandenen CCD-Sensoren (CCD: Charge-Coupled Device) oder CMOS-Sensoren (CMOS: Complementary Metal Oxide Semiconductor) bauartbedingt eine bestimmte Kennlinienform, die zwischen den Endgeräten nicht schwankt, so dass durch eine statistische Auswertung der Vielzahl von Messwerten eine äußerst genaue Bestimmung der Umweltgröße möglich ist. Für diese Auswertung kann beispielsweise ein Rekonstruktionsalgorithmus eingesetzt werden, wie beispielsweise der sogenannte "Filtered Back Projection"-Algorithmus oder der OPED-Algorithmus (OPED: Orthogonal Polynomial Expansion on the Disc) oder ein sonstiger iterativer Rekonstruktionsalgorithmus. Diese Rekonstruktionsalgorithmen sind an sich aus dem Stand der Technik bekannt und müssen deshalb nicht näher beschrieben werden.

Denkbar ist im Rahmen der Erfindung auch die Nutzung eines Mikrofons zur Strahlungsmessung.

Im Rahmen der statistischen Auswertung der Vielzahl von Messwerten kann die Statistikeinheit auch eine Glättung der Messwerte vornehmen und/oder einen Mittelwert der Messwerte berechnen. Darüber hinaus besteht im Rahmen der Erfindung die Möglichkeit, dass die Statistikeinheit die von den Endgeräten gemessenen Messwerte der Umweltgröße einer Plausibilitätsprüfung unterzieht.

Es wurde bereits vorstehend erwähnt, dass die zentrale Überwachungseinrichtung einen Gefahrenhinweis an die einzelnen Endgeräte überträgt, wobei der Gefahrenhinweis beispielsweise eine Fluchtempfehlung enthalten kann, um den Nutzern der Endgeräte eine möglichst schnelle Flucht aus einem gefährdeten Gebiet zu ermöglichen. Beispielsweise kann die Fluchtempfehlung eine empfohlene Fluchtrichtung, ein empfohlenes Verkehrsmittel (z.B. Kraftfahrzeug, Eisenbahn, zu Fuß) und/oder eine Empfehlung eines bestimmten Verkehrsweges (z.B. Vermeidung von Autobahnen) enthalten. Darüber hinaus besteht im Rahmen der Erfindung die Möglichkeit, dass der Gefahrenhinweis ein bestimmtes Fluchtziel angibt, um die Nutzer der Endgeräte beispielsweise zu einem nahegelegten Schutzraum zu leiten. Ferner besteht auch die Möglichkeit, dass die Alarmmeldung eine quantitative und/oder qualitative Information über die Umweltgröße an dem jeweiligen Standort des jeweiligen Endgeräts enthält.

Bei der Berechnung des Gefahrenhinweises in der Überwachungseinrichtung können auch Wettermeldungen berücksichtigt werden, die das Wetter in dem überwachten Gebiet vorhersagen. Dies ist sinnvoll, da sich beispielsweise Strahlungswolken entsprechend dem jeweiligen Wetter in dem überwachten Gebiet ausbreiten und verschiedene Niederschläge Radionuklide in erhöhter Konzentration auf betroffene Gebiete aufbringen.

Ferner beseht auch die Möglichkeit, dass bei der Berechnung des Gefahrenhinweises Verkehrsmeldungen über den Verkehr in dem überwachten Gebiet berücksichtigt werden. So können beispielsweise Fluchtempfehlungen so berechnet werden, dass Verkehrsstaus nach Möglichkeit verhindert werden.

Hinsichtlich der Kommunikation zwischen den einzelnen Endgeräten und der zentralen Überwachungseinrichtung bestehen im Rahmen der Erfindung verschiedene Möglichkeiten.

Eine Möglichkeit sieht vor, dass die zentrale Überwachungseinrichtung die Endgeräte aktiv abfragt ("Polling"), woraufhin dann die Endgeräte den Messwert der Umweltgröße und ggf. die vorstehend beschriebenen weiteren Größen (z.B. Position) an die Überwachungseinrichtung übertragen.

Eine andere Möglichkeit sieht dagegen vor, dass die Endgeräte den gemessenen Wert der Umweltgröße und ggf. auch die vorstehend beschriebenen weiteren Größen (z.B. Position) aktiv an die Überwachungseinrichtung übertragen, beispielsweise, wenn der Messwert der Umweltgröße einen Grenzwert übersteigt.

Weiterhin ist zu erwähnen, dass die Erfindung nicht nur Schutz beansprucht für die vorstehend beschriebene zentrale Überwachungseinrichtung, sondern auch für ein entsprechend angepasstes Endgerät (z.B. Telekommunikations-Endgerät, Mobiltelefon, Laptop, Netbook, Notebook, etc.), das einen Sensor aufweist, der zum Messen der Umweltgröße geeignet ist und den gemessenen Messwert dann mittels eines Senders an die Überwachungseinrichtung übertragen kann. Als Sensor für die Messung von radioaktiver Strahlung kann beispielsweise ein Bildsensor (z.B. CCD-Sensor, CMOS-Sensor) eingesetzt werden, der in modernen Mobiltelefonen und tragbaren Computern ohnehin vorhanden ist und deshalb auch zur Strahlungsmessung verwendet werden kann. Die Anpassung des verwendeten Endgeräts für den erfindungsgemäßen Zweck kann wahlweise softwaremäßig (z.B. mit einem geeigneten Anwendungsprogramm) und/oder hardwaremäßig erfolgen.

Bei der Verwendung eines herkömmlichen Bildsensors zur Strahlungsmessung erfolgt eine statistische Auswertung der Ausgangssignale der einzelnen Bildelemente des Bildsensors, wobei die zur Bilderfassung erforderliche Ortsauflösung verloren geht, aber dadurch ein relativ genauer Messwert erhalten werden kann.

Bei der Verwendung eines Bildsensors zur Strahlungsmessung wird der Bildsensor während der Messung der ionisierenden Strahlung vorzugsweise durch eine Abdeckung abgedeckt, wobei die Abdeckung für sichtbares Licht undurchlässig ist, während die Abdeckung für radioaktive Strahlung durchlässig ist. Dadurch wird erreicht, dass die Strahlungsmessung nicht durch einfallendes sichtbares Licht gestört wird.

Ferner ist zu erwähnen, dass die als Endgerät vorzugsweise verwendeten Mobiltelefone heute üblicherweise einen Programmspeicher aufweisen, in dem Anwendungsprogramme ("Apps") gespeichert werden können. Diese Anwendungsprogramme können dann von einem Prozessor in dem jeweiligen Endgerät (z.B. Mobiltelefon) ausgeführt werden. Die Erfindung sieht nun vor, dass in dem Programmspeicher ein Anwendungsprogramm gespeichert wird, das die erfindungsgemäße Messwerterfassung und die Datenkommunikation durchführt.

Hierbei ist zu berücksichtigen, dass der Messwert der radioaktiven Strahlung auch von der räumlichen Ausrichtung der als Strahlungssensor verwendeten Digitalkamera abhängt. Falls beispielsweise die Digitalkamera des Mobiltelefons unmittelbar auf die Strahlungsquelle ausgerichtet ist, so wird ein höherer Strahlungswert gemessen, als wenn die Digitalkamera von der Strahlungsquelle abgewandt ist bzw. wenn sich ein Hindernis (z.B. der Benutzer) zwischen der Digitalkamera und der Strahlungsquelle befindet. Das Anwendungsprogramm misst den Messwert der Umweltgröße deshalb vorzugsweise iterativ in mehreren Iterationsschritten mit unterschiedlichen räumlichen Ausrichtungen des Endgeräts. In den einzelnen Iterationsschritten wird jeweils ein Messwert gemessen, wobei zwischen den einzelnen Iterationsschritten eine Richtungsempfehlung bestimmt wird, die dem Benutzer des Endgeräts angezeigt wird und den Benutzer veranlasst, das Endgerät für die Messung in eine bestimmte Richtung entsprechend der Richtungsempfehlung auszurichten. Die Iteration wird dann vorzugsweise so lange wiederholt, bis die Ausrichtung des Endgeräts zu einem maximalen Messwert geführt hat, der dann an die zentrale Überwachungseinrichtung übertragen wird.

Schließlich ist noch zu erwähnen, dass die Erfindung auch ein komplettes Überwachungssystem umfasst mit der vorstehend beschriebenen zentralen Überwachungseinrichtung und einer Vielzahl von elektronischen Endgeräten zur Messung der überwachten Umweltgröße.

In einem derartigen Überwachungssystem kann eine direkte Datenverbindung vorgesehen sein zwischen den einzelnen Endgeräten, insbesondere in Form einer Bluetooth-Verbindung oder einer WLAN-Verbindung.

Zum einen kann diese direkte Datenverbindung zwischen den einzelnen Endgeräten genutzt werden, um in einem Mobilfunknetz einem Mobiltelefon einen Netzzugang über einen Umweg zu ermöglichen. Falls also ein Mobiltelefon keinen unmittelbaren Netzzugang hat, so kann dieses Mobiltelefon zunächst eine Verbindung zu einem anderen Endgerät herstellen und dann den Messwert und die vorstehend beschriebenen weiteren Informationen auf diesem Umweg an die zentrale Überwachungseinrichtung übertragen.

Zum anderen ermöglicht die direkte Verbindung zwischen zwei Endgeräten aber auch eine Kalibrierung der Endgeräte ebenso wie den Vergleich eines gemessenen Strahlungswerts mit dem Wert der rekonstruierten Strahlungskarte.

Ferner ist zu erwähnen, dass die Erfindung auch entsprechende Betriebsverfahren für die einzelnen Endgeräte und für die zentrale Überwachungseinrichtung umfasst, wie sich bereits aus der vorstehenden Beschreibung ergibt.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:

Figur 1                 eine schematische Darstellung eines Überwa-chungssystems zur Überwachung radioaktiver Strahlung mit einer zentralen Überwachungseinrichtung und einer Vielzahl von Endgeräten zur Strahlungsmessung,

Figur 2                 eine schematische Darstellung der Überwachungseinrichtung aus Figur 1,

Figuren 3A und 3B    das Betriebsverfahren der Endgeräte aus Figur 1 in Form eines Flussdiagramms.

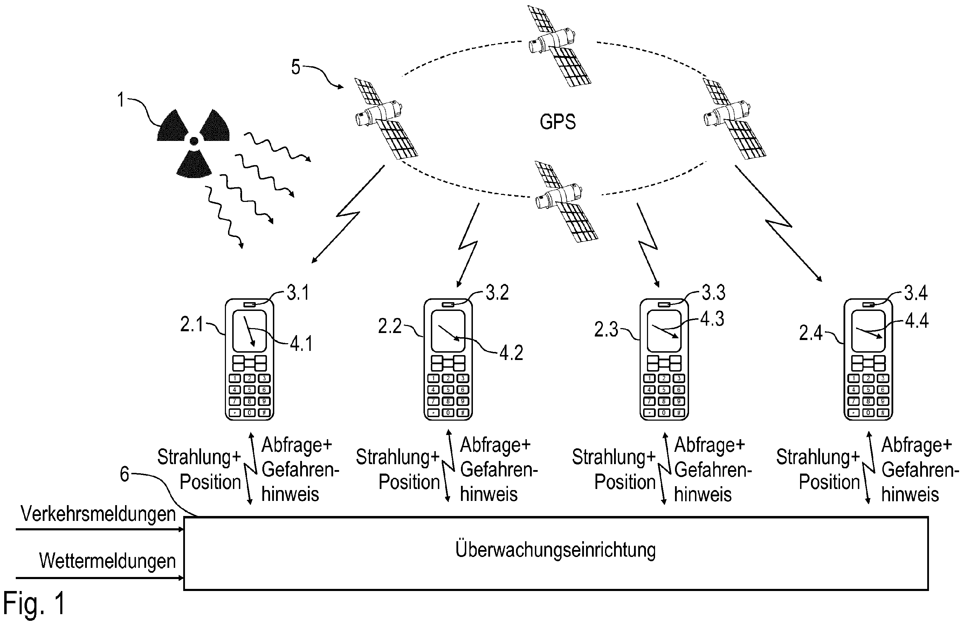

Figur 1 zeigt in schematischer Form ein erfindungsgemäßes Überwachungssystem zur flächendeckenden Strahlungsüberwachung, wobei das Überwachungssystem beispielsweise die Detektion einer sogenannten schmutzigen Bombe 1 ermöglicht und auch die Bestimmung der geografischen Position der schmutzigen Bombe 1 erlaubt. Das erfindungsgemäße Überwachungssystem eignet sich jedoch auch zur Bestimmung der Intensität und der geografischen Position anderer Strahlungsquellen, wie beispielsweise von Strahlungswolken, die durch Störfälle in kerntechnischen Anlagen entstanden sind.

Zur Strahlungsmessung setzt das erfindungsgemäße Überwachungssystem herkömmliche Mobiltelefone 2.1-2.4 ein, die in sehr großer Anzahl und guter räumlicher Verteilung in dem überwachten Gebiet ohnehin vorhanden sind. Die hohe Anzahl der zur Strahlungsmessung eingesetzten Mobiltelefone 2.1-2.4 und die gute räumliche Verteilung sorgen dafür, dass eine Vielzahl von Messwerten bereitgestellt werden kann, was im Wege einer statistischen Auswertung eine sehr genaue Bestimmung der räumlichen Verteilung der Strahlenwerte ermöglicht. So weist das eingangs beschriebene ODL-Messnetz in Deutschland nur weniger als 3000 Messstellen auf, wohingegen in Deutschland mehrere Millionen Mobiltelefone im Einsatz sind, die über eine Digitalkamera verfügen und deshalb im Rahmen des erfindungsgemäßen Überwachungssystems auch zur Strahlungsmessung eingesetzt werden können, zumal in Brennpunkten (z.B. Stadien, Flughäfen) eine solche Dichte der Mobiltelefone 2.1-2.4 vorhanden ist, dass eine lokale Gefährdungsdetektion möglich ist.

So verfügen die Mobiltelefone 2.1-2.4 jeweils über eine Digitalkamera 3.1-3.4, die jeweils einen Bildsensor (z.B. CCD-Sensor, CMOS-Sensor) enthält, der nicht nur für sichtbares Licht empfindlich ist, sondern auch für radioaktive Strahlung und deshalb zur Strahlungsmessung eingesetzt werden kann.

Darüber hinaus verfügen die einzelnen Mobiltelefone 2.1-2.4 jeweils über ein Display, auf dem ein Gefahrenhinweis 4.1-4.4 angezeigt werden kann, wobei der Gefahrenhinweis noch eingehend erläutert wird.

Ferner verfügen die einzelnen Mobiltelefone 2.1-2.4 jeweils über ein integriertes GPS-Modul (GPS: Global Positioning System) zur Bestimmung der geografischen Position des jeweiligen Mobiltelefons 2.1-2.4 mittels eines satellitengestützten GPS-Systems 5, das hier nur schematisch dargestellt ist und an sich aus dem Stand der Technik bekannt ist, so dass auf eine Beschreibung der Funktionsweise des GPS-Systems 5 verzichtet werden kann.

Die einzelnen Mobiltelefone 2.1-2.4 messen mittels der Digitalkameras 3.1-3.4 einen Strahlungswert am Ort des jeweiligen Mobiltelefons 2.1-2.4. Darüber hinaus erfassen die einzelnen Mobiltelefone 2.1-2.4 mittels des integrierten GPS-Moduls die jeweilige geografische Position des Mobiltelefons 2.1-2.4.

Der Messwert des Strahlungswerts wird dann zusammen mit der geografischen Position von den einzelnen Mobiltelefonen 2.1-2.4 an eine zentrale Überwachungseinrichtung 6 übertragen, die aus den eingehenden Messwerten der Vielzahl der Mobiltelefone 2.1-2.4 eine Strahlungskarte erstellt, welche die geografische Verteilung der Strahlungswerte in dem überwachten Gebiet wiedergibt.

Die Überwachungseinrichtung 6 ermittelt dann anhand der Strahlungskarte unter Berücksichtigung von eingehenden Verkehrsmeldungen und Wettermeldungen die bereits vorstehend erwähnten Gefahrenhinweise 4.1, 4.4, die beispielsweise eine Fluchtempfehlung enthalten können, wie durch die Pfeile in der Zeichnung angedeutet wird, wobei diese Berechnung alternativ auch in den Mobiltelefonen 2.1-2.4 erfolgen kann. Darüber hinaus können die von der Überwachungseinrichtung an die Endgeräte 2.1-2.4 übertragenen Gefahrenhinweise auch eine Information enthalten über die geografische Position der schmutzigen Bombe 1 oder über die Intensität der Strahlung am Ort des jeweiligen Mobiltelefons 2.1-2.4.

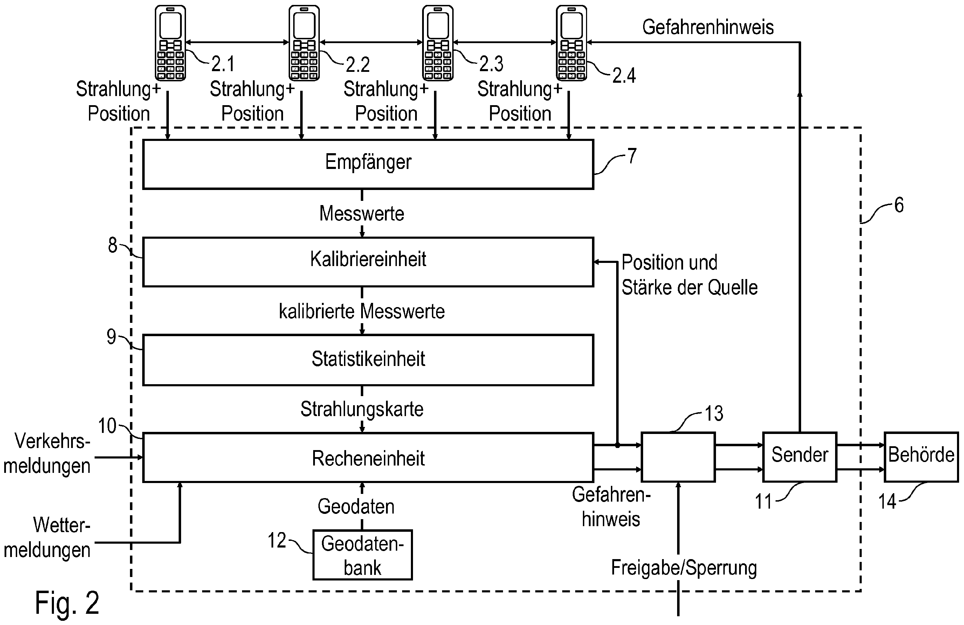

Figur 2 zeigt in schematischer Form den Aufbau und die Funktionsweise der zentralen Überwachungseinrichtung 6 aus Figur 1.

So weist die Überwachungseinrichtung 6 zunächst einen Empfänger 7 auf, wobei der Empfänger 7 von den Mobiltelefonen 2.1-2.4 die jeweiligen Messwerte der radioaktiven Strahlung und die jeweilige geografische Position des jeweiligen Mobiltelefons 2.1-2.4 empfängt.

Darüber hinaus enthält die Überwachungseinrichtung 6 eine Kalibriereinheit 8, um die eingehenden Messwerte der radioaktiven Strahlung zu kalibrieren. Hierbei ist zu erwähnen, dass die einzelnen Mobiltelefone 2.1-2.4 hinsichtlich der Strahlungsmessung nicht kalibriert sind und deshalb nur relativ ungenaue, nicht kalibrierte Messwerte an die Übertragungseinrichtung 6 übertragen. Allerdings weisen die zur Strahlungsmessung eingesetzten Digitalkameras 3.1-3.4 jeweils Bildsensoren mit einer einheitlichen Sensorkennlinie auf, wobei die Sensorkennlinie bauartbedingt ist. Die Einheitlichkeit der Sensorkennlinien in den verschiedenen Mobiltelefonen 2.1-2.4 kann in der Kalibriereinheit 8 von einem Rekonstruktionsalgorithmus (z.B. "Orthogonal Polynomial Expansion on Disc", OPED) genutzt werden, um die Messwerte zu kalibrieren.

Darüber hinaus weist die Überwachungseinrichtung 6 eine Statistikeinheit 9 auf, um die kalibrierten Messwerte statistisch auszuwerten. Im Rahmen der statistischen Auswertung in der Statistikeinheit 9 können beispielsweise Ausreißer der Messwerte eliminiert werden und darüber hinaus können beispielsweise Mittelwerte der zahlreichen Messwerte gebildet werden. Die Statistikeinheit 9 gibt dann eine Strahlungskarte an eine Recheneinheit 10 aus, wobei die Strahlungskarte die geografische Verteilung der gemessenen Strahlungswerte (z.B. Orts-Dosisleistung) wiedergibt.

Die Recheneinheit berechnet dann in Abhängigkeit von der Strahlungskarte die Position und die Stärke der schmutzigen Bombe 1, um die schmutzige Bombe 1 lokalisieren zu können. Darüber hinaus wird die ermittelte Position und Stärke der schmutzigen Bombe 1 an die Kalibriereinheit 8 zurückgemeldet, um die Kalibrierung zu optimieren.

Darüber hinaus berechnet die Recheneinheit 10 aus der Strahlungskarte unter Berücksichtigung von Verkehrsmeldungen und Wettermeldungen einen Gefahrenhinweis, der von einem Sender 11 an die Mobiltelefone 2.1-2.4 übertragen wird, um die Nutzer der Mobiltelefone 2.1-2.4 über eine mögliche Gefahr zu informieren.

Bei der Berechnung des Gefahrenhinweises berücksichtigt die Recheneinheit 10 auch geografische Daten (z.B. Geländedaten, Gebäudedaten, etc.), die in einer Geodatenbank 12 gespeichert sind. So können beispielsweise Geländeformationen (z.B. Berge) zu einer lokalen Abschwächung der Strahlungswerte führen, was bei der Bestimmung des Gefahrenhinweises berücksichtigt werden sollte.

Darüber hinaus kann die Geodatenbank 12 beispielsweise auch Gebäudedaten enthalten, wie beispielsweise die Position von Schutzräumen für die Bevölkerung, damit die Recheneinheit 10 dann entsprechende Fluchtempfehlungen an die Nutzer der Mobiltelefone 2.1-2.4 ausgeben kann.

Zwischen der Recheneinheit 10 und dem Sender 11 ist hierbei ein Freigabeelement 13 angeordnet, das es erlaubt, die Ausgabe des Gefahrenhinweises und der Informationen über die Position und Stärke der schmutzigen Bombe 1 wahlweise freizugeben oder zu sperren, um beispielsweise Panik in der Bevölkerung zu vermeiden.

Darüber hinaus ist noch zu erwähnen, dass der Sender 11 den Gefahrenhinweis und die Position und Stärke der schmutzigen Bombe 1 auch an Behörden 14 weitergibt, um Maßnahmen gegen die schmutzige Bombe 1 ergreifen zu können.

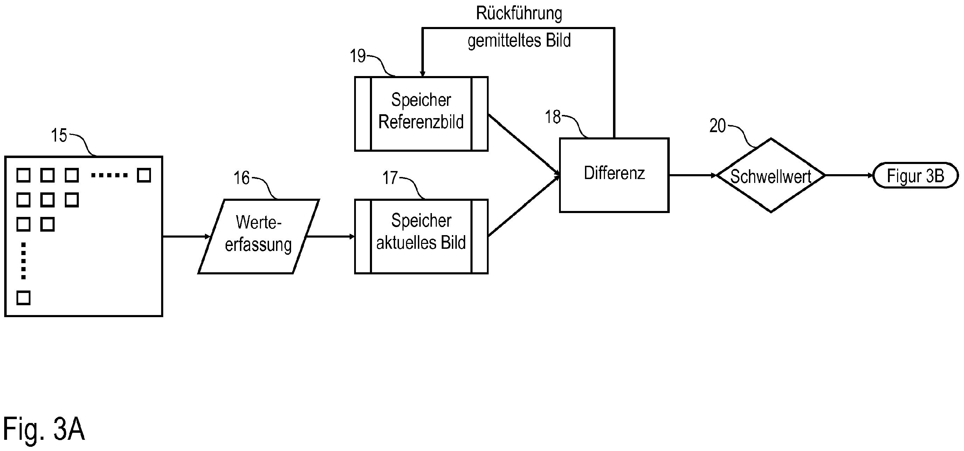

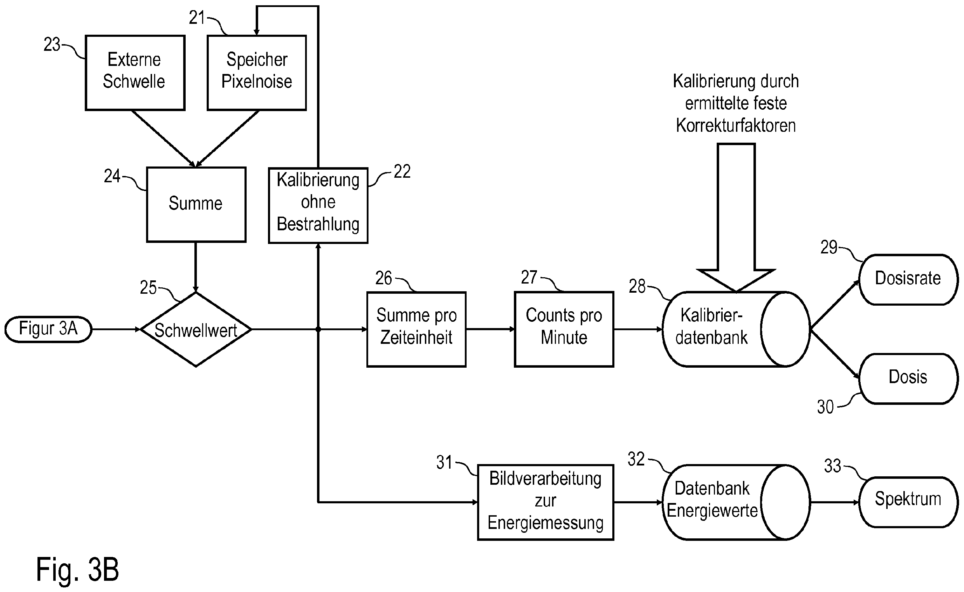

Die Figuren 3A und 3B zeigen das erfindungsgemäße Betriebsverfahren für die Mobiltelefone 2.1-2.4 in Form eines Flussdiagramms.

Zunächst zeigen die Zeichnungen einen Bildsensor 15 mit zahlreichen matrixförmig angeordneten Bildelementen zur Strahlungsmessung. Bei dem Bildsensor 15 kann es sich beispielsweise um einen CCD-Sensor oder um einen CMOS-Sensor handeln.

In einem Schritt 16 erfolgt eine Werteerfassung der von dem Bildsensor 15 gemessenen Bilder mit einer Frame-Rate von 40-60 fps (frames per second). Alternativ ist beispielsweise auch eine Frame-Rate von 15-24 fps möglich. Optional sind auch Einzelbilder möglich, die dann ggf. mit Shutter-Zeiten, die Teilbilderaufnahmen entsprechen oder umgekehrt Langzeitbelichtungen mit ganz großen Shutter-Zeiten.

Die gemessenen Bilder werden dann in einem Schritt 17 in einem Bildspeicher gespeichert.

Anschließend erfolgt in einem Schritt 18 eine Differenzbildung zwischen dem in dem Schritt 17 gespeicherten aktuellen Bild und einem in einem Schritt 19 gespeicherten Referenzbild, wobei ein Referenzspeicher eine Durchschnittshelligkeit pro Bildelement (Pixel) von den vorherigen Bildaufnahmen enthält. Die somit erreichte Mittelung kann in Abhängigkeit von der aktuellen Differenz erfolgen, beispielsweise nach folgender Formel:

$$\texttt{Ref = Ref} \cdot \texttt{n + neues Pixel} \cdot \texttt{m/(n+m)}$$

mit

Ref: Helligkeit des Referenzbilds
n: Gewichtungsfaktor für die Berücksichtigung des Referenzbildes mit n+m=1
m: Gewichtungsfaktor für die Berücksichtigung des neuen Bildes mit n+m=1
neues Pixel: Helligkeit des neuen Bildes

Die so ermittelte Differenz wird dann in einem Schritt 20 mit einem oberen Grenzwert und einem unteren Grenzwert verglichen, wobei ein Zählereignis ausgelöst wird, wenn der gemessene Differenzwert zwischen dem oberen Grenzwert und dem unteren Grenzwert liegt.

Optional besteht die in Figur 3B dargestellte Möglichkeit eines Speichers 21 für Pixelrauschen, der bei einem Kalibriervorgang 22 mit den Rauschwerten pro Pixel gefüllt wird. Dazu werden mehrere Messungen bei Dunkelheit und ohne zusätzliche Bestrahlung durchgeführt. Die einzelnen Differenzen zwischen aktuellem Bild und letztem Bild werden mit einer Matrix aufsummiert (Rauschwerte pro Pixel) und dann z.B. maximale Werte bzw. nach statistischer Auswertung die ermittelten Werte gespeichert (Gauß-Verteilung unter Berücksichtigung von einfallender Background-Strahlung). Darüber hinaus kann eine externe Schwelle 23 hinzugefügt werden, die auf die Pixelschwelle aus dem Speicher 21 in einem Schritt 24 aufaddiert werden kann, was für stabilere Ergebnisse sorgt.

Ein Schwellenwertvergleich 25 liefert dann ein analoges oder digitales Signal, wenn Schwellenwerte überschritten bzw. - bei negativem Vorzeichen - unterschritten werden. In einem Schritt 26 werden die Zählereignisse dann über eine bestimmte Zeiteinheit aufsummiert.

Daraufhin wird in einem Schritt 27 die Anzahl der Zählereignisse (Counts) pro Minute berechnet.

Über eine Kalibriertabelle 28 wird dann die Zuordnung zu einer Dosisleistung (z.B. aus Counts pro Minute) bzw. Dosis (aus Gesamtzahl der Counts) erstellt. Die Kalibrierungstabelle kann für eine Gruppe von Sensoren oder individuell erstellt werden durch einen Messvorgang mit kalibrierter Strahlungsquelle. Optional kann ein Korrekturfaktor zur vereinfachten Kalibrierung mit ein oder zwei Punkten vorgesehen sein.

Im Ergebnis wird dann in einem Schritt 29 eine Dosisrate und in einem Schritt 30 eine Dosis ausgegeben.

Darüber hinaus besteht auch die Möglichkeit für eine Bildverarbeitung 31 zur Ermittlung der Energiewerte der einfallenden Photonen. So lösen niedrigenergetische Photonen in der Regel nur ein Zählereignis in einem einzigen Bildelement des Bildsensors 6 aus. Hochenergetische Photonen führen dagegen zu einem Übersprechen zwischen benachbarten Bildelementen des Bildsensors 6, so dass eine Gruppe (Cluster) von mehreren benachbarten Bildelementen des Bildsensors 6 ein Zählereignis auslöst. Durch die Bildverarbeitung 31 können dann derartige Gruppen von aktivierten Bildelementen ermittelt werden, wodurch sich näherungsweise eine Spektralverteilung berechnen lässt. Die so gewonnenen Werte werden mit einer Datenbank 32 der Energiewerte verglichen, woraufhin dann in einem Schritt 33 ein Spektrum der einfallenden Strahlung ausgegeben wird.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen. Darüber hinaus beansprucht die Erfindung auch Schutz für den Gegenstand und die Merkmale der Unteransprüche unabhängig von den in Bezug genommenen Ansprüchen.

Weiterhin umfasst die Erfindung eine Überwachungseinrichtung (6) zur Umweltüberwachung, insbesondere zur Umweltüberwachung von radioaktiver Strahlung, mit mindestens einem Empfänger (7) zum Empfangen von Messwerten einer potentiell gesundheitsgefährdenden Umweltgröße, einer Recheneinheit (10) zur Berechnung eines Gefahrenhinweises (4.1-4.4) in Abhängigkeit von den Messwerten, wobei der Empfänger (7) ausgelegt ist für den Empfang der Messwerte von einer Vielzahl von räumlich verteilt angeordneten elektronischen Endgeräten (2.1-2.4), insbesondere von Mobiltelefonen (2.1-2.4) mit einem Sensor zur Messung der radioaktiven Strahlung, insbesondere mit einem Bildsensor.

Weiterhin umfasst die Erfindung eine solche Überwachungseinrichtung (6) mit einen Sender (11) zum Übertragen des Gefahrenhinweises (4.1-4.4) an die elektronischen Endgeräte (2.1-2.4), wobei der Gefahrenhinweis (4.1-4.4) die Nutzer der Endgeräte (2.1-2.4) über eine mögliche Gesundheitsgefahr aufgrund der Messwerte der Umweltgröße informiert.

Weiterhin umfasst die Erfindung eine solche Überwachungseinrichtung (6), wobei die Recheneinheit (10) den Gefahrenhinweis (4.1-4.4) in Abhängigkeit von der geografischen Position der einzelnen Endgeräte (2.1-2.4) berechnet.

Weiterhin umfasst die Erfindung eine solche Überwachungseinrichtung (6), wobei die geografische Position der einzelnen Endgeräte (2.1-2.4) jeweils von den einzelnen Endgeräten (2.1-2.4) ermittelt wird, insbesondere mittels eines Satellitennavigationssystems, und zusätzlich zu dem Messwert der Umweltgröße an die Überwachungseinrichtung (6) übertragen wird, und/oder wobei die Überwachungseinrichtung (6) die geografische Position der einzelnen Endgeräte (2.1-2.4) ermittelt, insbesondere durch eine Zellenortung der Funkzelle des jeweiligen Endgeräts in einem zellulären Mobilfunknetz, oder eine Ortung des zugehörigen Wireless-Access-Points bei einer WLAN-Anbindung der Endgeräte (2.1-2.4).

Weiterhin umfasst die Erfindung eine solche Überwachungseinrichtung (6) wobei die Überwachungseinrichtung (6) eine Geodatenbank (12) aufweist, welche geografische Daten eines geografischen Gebiets enthält, in dem sich die Endgeräte (2.1-2.4) befinden, wobei die Recheneinheit (10) den Gefahrenhinweis (4.1-4.4) in Abhängigkeit von den in der Geodatenbank (12) gespeicherten geografischen Daten berechnet.

Weiterhin umfasst die Erfindung eine solche Überwachungseinrichtung (6) wobei die von den Endgeräten (2.1-2.4) gemessene Umweltgröße eine Strahlungsgröße ist, die eine radioaktive Strahlung wiedergibt, wobei die in der Geodatenbank (12) gespeicherten geografischen Daten dreidimensionale Geländedaten und und/oder dreidimensionale Bauwerksdaten umfassen, die einen Einfluss auf die Abschwächung der radioaktiven Strahlung haben, wobei die Recheneinheit (10) eine räumliche Verteilung einer Strahlenbelastung berechnet in Abhängigkeit von den in der Geodatenbank (12) gespeicherten geografischen Daten, insbesondere unter Berücksichtigung der Abschwächung der radioaktiven Strahlung, und den von den Endgeräten (2.1-2.4) gemessenen Messwerten der Strahlungsgröße, und den geografischen Positionen der Endgeräte (2.1-2.4).

Weiterhin umfasst die Erfindung eine solche Überwachungseinrichtung (6), wobei die Überwachungseinrichtung (6) eine Statistikeinheit (9) aufweist zur statistischen Auswertung der von den Endgeräten (2.1-2.4) gemessenen Messwerte der Umweltgröße und der zugehörigen geografischen Positionen der Endgeräte (2.1-2.4), und/oder wobei die Statistikeinheit (9) die von den Endgeräten (2.1-2.4) gemessenen Messwerte der Umweltgröße statistisch glättet, und/oder wobei die Statistikeinheit (9) aus den von den Endgeräten (2.1-2.4) gemessenen Messwerten einen Mittelwert berechnet, und/oder wobei die Statistikeinheit (9) die von den Endgeräten (2.1-2.4) gemessenen Messwerte der Umweltgröße einer Plausibilitätsprüfung unterzieht, und/oder wobei die Statistikeinheit (9) aus den von den Endgeräten (2.1-2.4) gemessenen Messwerten Ausreißer ermittelt und die Ausreißer bei der weiteren Auswertung nicht berücksichtigt.

Weiterhin umfasst die Erfindung eine solche Überwachungseinrichtung (6), wobei der an die Endgeräte (2.1-2.4) übertragene Gefahrenhinweis (4.1-4.4) mindestens eine der folgenden Informationen enthält:

- eine Fluchtempfehlung, insbesondere mit einer Empfehlung einer bestimmten Fluchtrichtung und/oder eines bestimmten Verkehrsmittels und/oder eines bestimmten Verkehrsweges und/oder eines bestimmten Fluchtziels,
- eine Alarmmeldung mit einer quantitativen und/oder qualitativen Information über die Umweltgröße.

Weiterhin umfasst die Erfindung eine solch Überwachungseinrichtung (6), wobei die Recheneinheit (10) den Gefahrenhinweis (4.1-4.4) in Abhängigkeit von mindestens einer der folgenden Informationen berechnet:

- Wettermeldungen über das Wetter in dem Gebiet, in dem sich die Endgeräte (2.1-2.4) befinden,
- Verkehrsmeldungen über den Verkehr in dem Gebiet, in dem sich die Endgeräte (2.1-2.4) befinden.

Weiterhin umfasst die Erfindung eine solche Überwachungseinrichtung (6), wobei die von den Endgeräten (2.1-2.4) gemessene Umweltgröße eine Strahlungsgröße ist, die eine radioaktive Strahlung wiedergibt, die von einer Strahlungsquelle herrührt, insbesondere von einer schmutzigen Bombe, wobei die Recheneinheit (10) aus den geografischen Positionen der Endgeräte (2.1-2.4) und den von den Endgeräten (2.1-2.4) gemessenen Messwerten der Strahlungsgröße die geografische Position der Strahlungsquelle und/oder die Strahlungsleistung der Strahlungsquelle berechnet, insbesondere mittels eines Rekonstruktionsalgorithmus.

Weiterhin umfasst die Erfindung eine solche Überwachungseinrichtung (6), wobei die Messwerte ungleichmäßig verteilt sind, und wobei der Rekonstruktionsalgorithmus einen der folgenden Rekonstruktionsalgorithmen umfasst:

- Filtered back projection,
- Orthogonal Polynomial Expansion on the Disc,
- einen iterativen Rekonstruktionsalgorithmus.

Weiterhin umfasst die Erfindung eine solche Überwachungseinrichtung (6), wobei die Überwachungseinrichtung (6) die Endgeräte (2.1-2.4) aktiv abfragt, wobei die Endgeräte (2.1-2.4) bei einer Abfrage durch die Überwachungseinrichtung (6) den Messwert der Umweltgröße an die Überwachungseinrichtung (6) übertragen, oder wobei die Endgeräte (2.1-2.4) den gemessenen Wert der Umweltgröße aktiv an die Überwachungseinrichtung (6) übertragen, insbesondere wenn der Messwert der Umweltgröße einen Grenzwert übersteigt.

Weiterhin umfasst die Erfindung ein Endgerät (2.1-2.4), insbesondere ein Mobiltelefon, mit einem Sender, wobei das Endgerät (2.1-2.4) einen Sensor (3.1-3.4) aufweist zum Messen eines Messwerts einer potentiell gesundheitsgefährdenden Umweltgröße, wobei der Sender den Messwert an eine Überwachungseinrichtung (6) überträgt.

Weiterhin umfasst die Erfindung ein solches Endgerät (2.1-2.4) mit einem Programmspeicher zur Speicherung eines Anwendungsprogramms und einem Prozessor zum Ausführen des in dem Programmspeicher gespeicherten Anwendungsprogramms, wobei das Abwendungsprogramm die Messung und Übertragung der Messwerte steuert.

Weiterhin umfasst die Erfindung ein solches Endgerät (2.1-2.4), wobei das Anwendungsprogramm den Messwert der Umweltgröße iterativ in mehreren Iterationsschritten ermittelt, wobei in den einzelnen Iterationsschritten jeweils ein Messwert der Umweltgröße gemessen wird, wobei zwischen den einzelnen Iterationsschritten eine Richtungsempfehlung bestimmt wird, die dem Benutzer des Endgerätes angezeigt wird und den Benutzer veranlasst, das Endgerät (2.1-2.4) für die Messung in eine bestimmte Richtung entsprechend der Richtungsempfehlung auszurichten, wobei die Richtungsempfehlung in Abhängigkeit von den in den einzelnen Iterationsschritten gemessenen Messwerten bestimmt wird, wobei von den in den einzelnen Iterationsschritten gemessenen Messwerten der größte Messwert für die Übertragung an die Überwachungseinrichtung (6) ausgewählt wird.

Weiterhin umfasst die Erfindung ein solches Endgerät (2.1-2.4), wobei der Sensor (3.1-3.4) ein Bildsensor ist mit einer Vielzahl von Bildelementen zur Aufnahme eines Bildes, wobei der Bildsensor (3.1-3.4) nicht nur für sichtbares Licht empfindlich ist, sondern auch für radioaktive Strahlung, und/oder wobei der Bildsensor (3.1-3.4) von einer Abdeckung abgedeckt ist, wobei die Abdeckung für sichtbares Licht undurchlässig und für die radioaktive Strahlung durchlässig ist.

Weiterhin umfasst die Erfindung ein Überwachungssystem zur Umweltüberwachung, insbesondere zur Umweltüberwachung von radioaktiver Strahlung, mit einer erfindungsgemäßen Überwachungseinrichtung (6) und zahlreichen erfindungsgemäßen elektronischen Endgeräten (2.1-2.4).

Weiterhin umfasst die Erfindung ein solches Überwachungssystem mit einer direkten Datenverbindung zwischen mindestens einem Paar der Endgeräte (2.1-2.4), insbesondere in Form einer Bluetooth-Verbindung oder einer WLAN-Verbindung.

Weiterhin umfasst die Erfindung ein solches Überwachungssystem, wobei die Endgeräte (2.1-2.4) die Messwerte der Umweltgröße über ein Mobilfunknetz an die Überwachungseinrichtung (6) übertragen, wobei die Endgeräte (2.1-2.4) die Messwerte bei fehlendem Netzzugang zu dem Mobilfunknetz über die direkte Datenverbindung zu einem anderen Endgerät (2.1-2.4) mit Netzzugang übertragen von wo die Messwerte dann über das Mobilfunknetz an die Überwachungseinrichtung (6) übertragen werden.

Weiterhin umfasst die Erfindung ein solches Überwachungssystem, wobei sich die Endgeräte (2.1-2.4) über die direkte Datenverbindung wechselseitig kalibrieren.

Bezugszeichenliste:

| | |
|---|---|
| 1 | Schmutzige Bombe |
| 2.1 | Mobiltelefon |
| 2.2 | Mobiltelefon |
| 2.3 | Mobiltelefon |
| 2.4 | Mobiltelefon |
| 3.1 | Digitalkamera |
| 3.2 | Digitalkamera |
| 3.3 | Digitalkamera |
| 3.4 | Digitalkamera |
| 4.1 | Gefahrenhinweis |
| 4.2 | Gefahrenhinweis |
| 4.3 | Gefahrenhinweis |
| 4.4 | Gefahrenhinweis |
| 5 | GPS-Systems |
| 6 | Überwachungseinrichtung |
| 7 | Empfänger |
| 8 | Kalibriereinheit |
| 9 | Statistikeinheit |

10      Recheneinheit
11      Sender
12      Geodatenbank
13      Freigabeelement
14      Behörden
15      Bildsensor
16      Schritt "Werteerfassung"
17      Schritt "Speichern"
18      Schritt "Differenzbildung"
19      Schritt "Referenzbild"
20      Schritt "Schwellenwertprüfung"
21      Speicher für Pixelrauschen
22      Kalibriervorgang
23      Externe Schwelle
24      Schritt "Summenbildung"
25      Schwellenwertvergleich
26      Schritt "Aufsummierung pro Zeiteinheit"
27      Schritt "Counts pro Minute"
28      Kalibriertabelle
29      Ausgabe Dosisrate
30      Ausgabe Dosis
31      Bildverarbeitung
32      Datenbank der Energiewerte
33      Ausgabe Spektrum

**Patentansprüche**

1.  Überwachungseinrichtung (6) zur Umweltüberwachung, insbesondere zur Umweltüberwachung von radioaktiver Strahlung, mit

    a) mindestens einem Empfänger (7) zum Empfangen von Messwerten einer potentiell gesundheitsgefährdenden Umweltgröße,
    b) einer Recheneinheit (10) zur Berechnung eines Gefahrenhinweises (4.1-4.4) in Abhängigkeit von den Messwerten und in Abhängigkeit von der geografischen Position der einzelnen Endgeräte (2.1-2.4),
    c) wobei der Empfänger (7) ausgelegt ist für den Empfang der Messwerte von einer Vielzahl von räumlich verteilt angeordneten elektronischen Endgeräten (2.1-2.4), insbesondere von Mobiltelefonen (2.1-2.4) mit einem Sensor zur Messung der radioaktiven Strahlung, insbesondere mit einem Bildsensor,
    **dadurch gekennzeichnet,**
    d) **dass** die Überwachungseinrichtung (6) dazu ausgelegt ist, die geografische Position der einzelnen Endgeräte (2.1-2.4) durch eine Ortung des zugehörigen Wireless-Access-Points bei einer WLAN-Anbindung der Endgeräte (2.1-2.4) zu ermitteln.

2.  Überwachungseinrichtung (6) nach Anspruch 1, **gekennzeichnet durch** einen Sender (11) zum Übertragen des Gefahrenhinweises (4.1-4.4) an die elektronischen Endgeräte (2.1-2.4), wobei der Gefahrenhinweis (4.1-4.4) dazu ausgelegt ist, die Nutzer der Endgeräte (2.1-2.4) über eine mögliche Gesundheitsgefahr aufgrund der Messwerte der Umweltgröße zu informieren.

3.  Überwachungseinrichtung (6) nach einem der vorhergehenden Ansprüche, **dadurch gekennzeichnet,**

    a) **dass** die einzelnen Endgeräte dazu ausgelegt sind, die geografische Position der einzelnen Endgeräte (2.1-2.4) zu ermitteln, insbesondere mittels eines Satellitennavigationssystems, und dass die einzelnen Endgeräte dazu ausgelegt sind, zusätzlich zu dem Messwert der Umweltgröße die geografische Position an die Überwachungseinrichtung (6) zu übertragen, und/oder
    b) **dass** die Überwachungseinrichtung (6) dazu ausgelegt ist, die geografische Position der einzelnen Endgeräte (2.1-2.4) durch eine Zellenortung der Funkzelle des jeweiligen Endgeräts in einem zellulären Mobilfunknetz zu ermitteln.

**4.** Überwachungseinrichtung (6) nach einem der vorhergehenden Ansprüche, **dadurch gekennzeichnet,**

a) **dass** die Überwachungseinrichtung (6) eine Geodatenbank (12) aufweist, welche geografische Daten eines geografischen Gebiets enthält, in dem sich die Endgeräte (2.1-2.4) befinden,
b) **dass** die Recheneinheit (10) dazu ausgelegt ist, den Gefahrenhinweis (4.1-4.4) in Abhängigkeit von den in der Geodatenbank (12) gespeicherten geografischen Daten zu berechnen.

**5.** Überwachungseinrichtung (6) nach Anspruch 4,
**dadurch gekennzeichnet,**

a) **dass** die von den Endgeräten (2.1-2.4) gemessene Umweltgröße eine Strahlungsgröße ist, die eine radioaktive Strahlung wiedergibt,
b) **dass** die in der Geodatenbank (12) gespeicherten geografischen Daten dreidimensionale Geländedaten und und/oder dreidimensionale Bauwerksdaten umfassen, die einen Einfluss auf die Abschwächung der radioaktiven Strahlung haben,
c) **dass** die Recheneinheit (10) dazu ausgelegt ist, eine räumliche Verteilung einer Strahlenbelastung zu berechnen in Abhängigkeit von

c1) den in der Geodatenbank (12) gespeicherten geografischen Daten, insbesondere unter Berücksichtigung der Abschwächung der radioaktiven Strahlung, und
c2) den von den Endgeräten (2.1-2.4) gemessenen Messwerten der Strahlungsgröße, und
c3) den geografischen Positionen der Endgeräte (2.1-2.4) .

**6.** Überwachungseinrichtung (6) nach einem der vorhergehenden Ansprüche, **dadurch gekennzeichnet, dass**

a) dass die Überwachungseinrichtung (6) eine Statistikeinheit (9) aufweist zur statistischen Auswertung der von den Endgeräten (2.1-2.4) gemessenen Messwerte der Umweltgröße und der zugehörigen geografischen Positionen der Endgeräte (2.1-2.4), und/oder
b) dass die Statistikeinheit (9) dazu ausgelegt ist, die von den Endgeräten (2.1-2.4) gemessenen Messwerte der Umweltgröße statistisch zu glätten, und/oder
c) dass die Statistikeinheit (9) dazu ausgelegt ist, aus den von den Endgeräten (2.1-2.4) gemessenen Messwerten einen Mittelwert zu berechnen, und/oder
d) dass die Statistikeinheit (9) dazu ausgelegt ist, die von den Endgeräten (2.1-2.4) gemessenen Messwerte der Umweltgröße einer Plausibilitätsprüfung zu unterziehen, und/oder
e) dass die Statistikeinheit (9) dazu ausgelegt ist, aus den von den Endgeräten (2.1-2.4) gemessenen Messwerten Ausreißer zu ermitteln und die Ausreißer bei der weiteren Auswertung nicht berücksichtigt.

**7.** Überwachungseinrichtung (6) nach einem der vorhergehenden Ansprüche, **dadurch gekennzeichnet, dass** der an die Endgeräte (2.1-2.4) übertragene Gefahrenhinweis (4.1-4.4) mindestens eine der folgenden Informationen enthält:

a) eine Fluchtempfehlung, insbesondere mit einer Empfehlung

a1) einer bestimmten Fluchtrichtung und/oder
a2) eines bestimmten Verkehrsmittels und/oder
a3) eines bestimmten Verkehrsweges und/oder
a4) eines bestimmten Fluchtziels,

b) eine Alarmmeldung mit einer quantitativen und/oder qualitativen Information über die Umweltgröße.

**8.** Überwachungseinrichtung (6) nach einem der vorhergehenden Ansprüche, **dadurch gekennzeichnet, dass** die Recheneinheit (10) dazu ausgelegt ist, den Gefahrenhinweis (4.1-4.4) in Abhängigkeit von mindestens einer der folgenden Informationen zu berechnen:

a) Wettermeldungen über das Wetter in dem Gebiet, in dem sich die Endgeräte (2.1-2.4) befinden,
b) Verkehrsmeldungen über den Verkehr in dem Gebiet, in dem sich die Endgeräte (2.1-2.4) befinden.

**9.** Überwachungseinrichtung (6) nach einem der vorhergehenden Ansprüche, **dadurch gekennzeichnet,**

a) **dass** die von den Endgeräten (2.1-2.4) gemessene Umweltgröße eine Strahlungsgröße ist, die eine radioaktive Strahlung wiedergibt, die von einer Strahlungsquelle herrührt, insbesondere von einer schmutzigen Bombe,

b) **dass** die Recheneinheit (10) dazu ausgelegt ist, aus den geografischen Positionen der Endgeräte (2.1-2.4) und den von den Endgeräten (2.1-2.4) gemessenen Messwerten der Strahlungsgröße die geografische Position der Strahlungsquelle und/oder die Strahlungsleistung der Strahlungsquelle zu berechnen, insbesondere mittels eines Rekonstruktionsalgorithmus.

**10.** Überwachungseinrichtung (6) nach Anspruch 9,
**dadurch gekennzeichnet,**

a) **dass** die Messwerte ungleichmäßig verteilt sind, und
b) **dass** der Rekonstruktionsalgorithmus einen der folgenden Rekonstruktionsalgorithmen umfasst:

b1) Filtered back projection,
b2) Orthogonal Polynomial Expansion on the Disc,
b3) einen iterativen Rekonstruktionsalgorithmus.

**11.** Überwachungseinrichtung (6) nach einem der vorhergehenden Ansprüche, **dadurch gekennzeichnet,**

a) **dass** die Überwachungseinrichtung (6) dazu ausgelegt ist, die Endgeräte (2.1-2.4) aktiv abzufragen, wobei die Endgeräte (2.1-2.4) bei einer Abfrage durch die Überwachungseinrichtung (6) den Messwert der Umweltgröße an die Überwachungseinrichtung (6) übertragen, oder
b) **dass** die Endgeräte (2.1-2.4) dazu ausgelegt sind, den gemessenen Wert der Umweltgröße aktiv an die Überwachungseinrichtung (6) zu übertragen, insbesondere wenn der Messwert der Umweltgröße einen Grenzwert übersteigt.

Fig. 1

Fig. 2

EP 3 528 013 A1

Fig. 3A

Fig. 3B

Europäisches
Patentamt

European
Patent Office

Office européen
des brevets

## EUROPÄISCHER RECHERCHENBERICHT

Nummer der Anmeldung

EP 19 16 6715

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2006/079208 A1 (KIM JEONG [US] ET AL) 13. April 2006 (2006-04-13) <br> * Absatz [0001] * <br> * Absatz [0015] - Absatz [0018] * <br> * Ansprüche * <br> * Abbildungen * <br> * Absatz [0022] - Absatz [0026] * <br> * Absatz [0003] * <br> * Absatz [0030] * <br> * Absatz [0011] * <br> ----- | 1,8-11 | INV. G01T7/00 |
| Y | WO 2004/079395 A2 (RANDOLPH & BALDWIN [US]; BALCHUNAS CURT [US]; ROGERS DAVID A [US]) 16. September 2004 (2004-09-16) <br> * Absatz [0002]; Abbildungen * <br> * Absatz [0029] - Absatz [0035] * <br> * Absatz [0052] * <br> * Absatz [0006] - Absatz [0007] * <br> * Absatz [0024] - Absatz [0025] * <br> * Absatz [0037] - Absatz [0040] * <br> * Absatz [0011] * <br> * Absatz [0028] * <br> * Absatz [0044] * <br> ----- | 1,3-6,11 | |
| Y | WO 2010/083006 A2 (RAMBUS INC [US]; BEST SCOTT [US]; BRONNER GARY [US]; TSERN ELY [US]) 22. Juli 2010 (2010-07-22) <br> * Absatz [0010] - Absatz [0011] * <br> * Absatz [0017] * <br> * Absatz [0020] - Absatz [0025]; Abbildungen * <br> * Absatz [0001] - Absatz [0002] * <br> * Ansprüche * <br> * Absatz [0019] * <br> * Absatz [0023] - Absatz [0024] * <br> ----- <br> -/-- | 1-3,5-7, 9,11 | |

RECHERCHIERTE SACHGEBIETE (IPC)

G01T

Der vorliegende Recherchenbericht wurde für alle Patentansprüche erstellt

| Recherchenort | Abschlußdatum der Recherche | Prüfer |
|---|---|---|
| Den Haag | 12. Juni 2019 | Eberle, Katja |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes Dokument

EPO FORM 1503 03.82 (P04C03)

Europäisches
Patentamt

European
Patent Office

Office européen
des brevets

# EUROPÄISCHER RECHERCHENBERICHT

Nummer der Anmeldung

EP 19 16 6715

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | US 7 218 938 B1 (LAU CHUNG [US] ET AL) 15. Mai 2007 (2007-05-15) * Spalte 13, Zeile 54 - Zeile 63 * ----- | 1-11 | |
| Y | DATABASE INSPEC [Online] THE INSTITUTION OF ELECTRICAL ENGINEERS, STEVENAGE, GB; 2010, SCHWARTZ T ET AL: "UbiSpot - A user trained always best positioned engine for mobile phones", XP002791791, Database accession no. 11678203 * Zusammenfassung * ----- | 1-11 | |
| Y | US 2009/012745 A1 (LONGMAN ANDREW [US] ET AL) 8. Januar 2009 (2009-01-08) * Absatz [0047] * ----- | 5 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| Den Haag | 12. Juni 2019 | Eberle, Katja |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument
......................................................................................................
& : Mitglied der gleichen Patentfamilie, übereinstimmendes
  Dokument

EPO FORM 1503 03.82 (P04C03)

Seite 2 von 2

## ANHANG ZUM EUROPÄISCHEN RECHERCHENBERICHT
## ÜBER DIE EUROPÄISCHE PATENTANMELDUNG NR.

EP 19 16 6715

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-06-2019

| Im Recherchenbericht angeführtes Patentdokument | Datum der Veröffentlichung | Mitglied(er) der Patentfamilie | Datum der Veröffentlichung |
|---|---|---|---|
| US 2006079208 A1 | 13-04-2006 | US 2006079208 A1<br>US 2007232296 A1 | 13-04-2006<br>04-10-2007 |
| WO 2004079395 A2 | 16-09-2004 | EP 1606654 A2<br>US 2006097171 A1<br>WO 2004079395 A2 | 21-12-2005<br>11-05-2006<br>16-09-2004 |
| WO 2010083006 A2 | 22-07-2010 | US 2011275356 A1<br>WO 2010083006 A2 | 10-11-2011<br>22-07-2010 |
| US 7218938 B1 | 15-05-2007 | US 7218938 B1<br>US 2008021645 A1<br>US 2014011524 A1<br>US 2015038168 A1<br>US 2016029175 A1<br>US 2016050533 A1<br>US 2017295462 A1 | 15-05-2007<br>24-01-2008<br>09-01-2014<br>05-02-2015<br>28-01-2016<br>18-02-2016<br>12-10-2017 |
| US 2009012745 A1 | 08-01-2009 | US 2009012745 A1<br>WO 2009006632 A2 | 08-01-2009<br>08-01-2009 |

EPO FORM P0461

Für nähere Einzelheiten zu diesem Anhang : siehe Amtsblatt des Europäischen Patentamts, Nr.12/82